# EUROPEAN PATENT SPECIFICATION

(11) **EP 1 176 721 B1**
(45) Date of publication and mention of the grant of the patent: **04.02.2004**
(21) Application number: 00830521.1
(22) Date of filing: 24.07.2000
(51) Int. Cl.: H03K 5/1532, G01R 19/04

(54) **Rail to rail rectifying integrator**
Integrator mit Gleichrichtungsfunktion und mit einem der Speisespannung entsprechenden Ausgangsspannungsbereich
Intégrateur à fonction de redressement de courant dont la gamme de tension de sortie est égale à la tension d'alimentation

(43) Date of publication of application: 30.01.2002
(73) Proprietor: STMicroelectronics S.r.l., 20041 Agrate Brianza (Milano) (IT)
(72) Inventor: Pernigotti, Elena, 10139 Torino (IT); Poma, Alberto, 27100 Pavia (IT); Protti, Carlo, 27100 Pavia (IT)
(74) Representative: Pellegri, Alberto

(56) References cited:
- DE-A- 3 114 770
- US-A- 4 109 308
- US-A- 4 554 508
- US-A- 5 281 860
- US-A- 5 614 851
- PATENT ABSTRACTS OF JAPAN vol. 008, no. 139 (E-253), 28 June 1984 (1984-06-28) & JP 59 050612 A (HITACHI SEISAKUSHO KK), 23 March 1984 (1984-03-23)
- PATENT ABSTRACTS OF JAPAN vol. 011, no. 294 (E-544), 22 September 1987 (1987-09-22) & JP 62 092774 A (HITACHI LTD;OTHERS: 01), 28 April 1987 (1987-04-28)
- PATENT ABSTRACTS OF JAPAN vol. 011, no. 245 (E-531), 11 August 1987 (1987-08-11) & JP 62 058879 A (HITACHI LTD;OTHERS: 01), 14 March 1987 (1987-03-14)

## Description

The present invention relates in general to a circuit for rectifying and integrating a signal relative to an intermediate reference voltage, outputting a rail-to-rail signal.

### BACKGROUND OF THE INVENTION

The document DE 3114770 A 1 discloses a peak-to-peak detector wherein the positive peak and the negative peak are fed to the inputs of an operational amplifier that sums the relative voltage information to produce an output signal.

The document US Patent No. 5,614,851 discloses a peak-to-peak CMOS voltage detector having a low power consumption.

US Patent No. 4,554,508 describes a carrier detector circuit including a rectification stage, an integrator, a comparator and a digital counter for establishing long time constance without requiring external components.

US Patent No. 5,281,860 discloses a method and apparatus for improved multiple channel sensor interface circuits, including a plurality of input integrator circuits, coupled in parallel, a switched capacitor multiplexer coupled to the input integrator circuits and an output integrator stage coupled to the switched capacitor multiplexer.

Japanese abstract of application No. 57161948 describes an A/D converter with polarity switching circuit, sample and old circuit and rectifying switched capacitor system.

Japanese abstract application No. 60231234 discloses a rectifying and smoothing circuit wherein the full-wave rectified voltage is smoothed and amplified by an arithmetic and a logic amplifier 5 and a switched capacitor.

Japanese abstract application No. 60194773 describes a rectifying circuit in which the input signal voltage is sampled and the negative samples inverted to avoid diode dissipation.

US Patent 4,109,308 discloses an AC to DC converter which includes two resetable integrators each for sampling an alternate half-wave of the AC voltage to be converted.

Rectifying and integrating circuits of an alternating input voltage in respect to a reference voltage are used in many applications and are included in many commercially available devices.

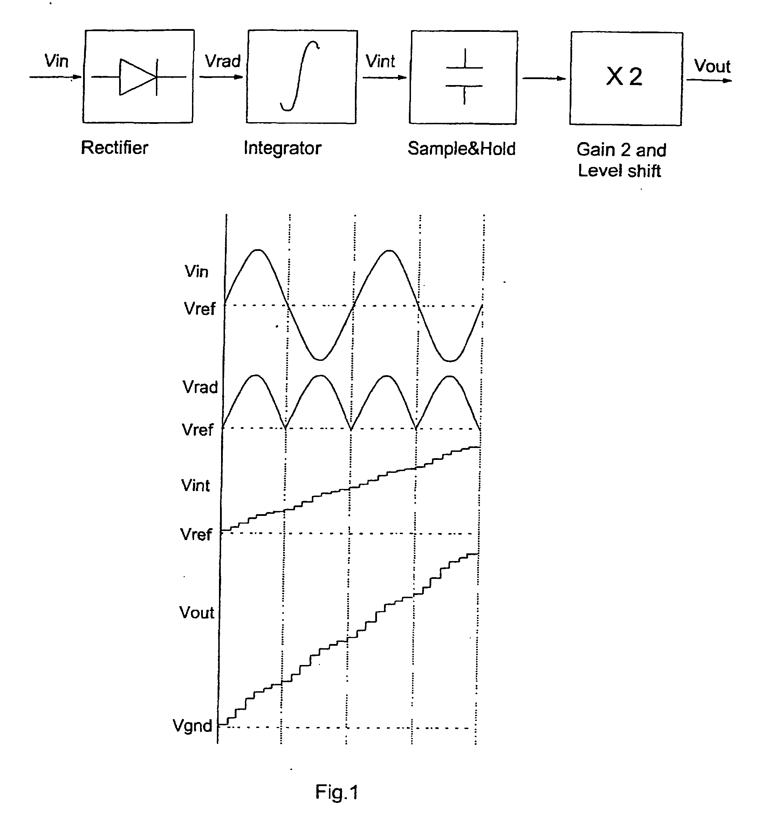

A rectifying integrator circuit may be realized, as depicted in the basic scheme of Figure 1, by a rectifier having in cascade thereto an integrator stage and a Sample&Hold stage.

However, by using these three blocks alone it is possible to obtain an output voltage that varies between the voltage reference (VREF) and the maximum (or the minimum) input voltage, that is with a reduced dynamic, rather than between the minimum and the maximum input voltage, as it would be preferred. In particular, if the voltage reference corresponds to the intermediate value between the maximum and minimum input voltage V_{IN}, the dynamic of the output voltage is practically halved if compared to the maximum input dynamic.

This drawback may be averted by placing in cascade to the three above mentioned blocks, an output stage having a gain value equal to two and which also functions as a level shifter, thus obtaining an output voltage Vout with a full dynamic. The disadvantage of this solution is the fact that a gain stage placed at the end of the cascade sensibly lowers the signal/noise ratio.

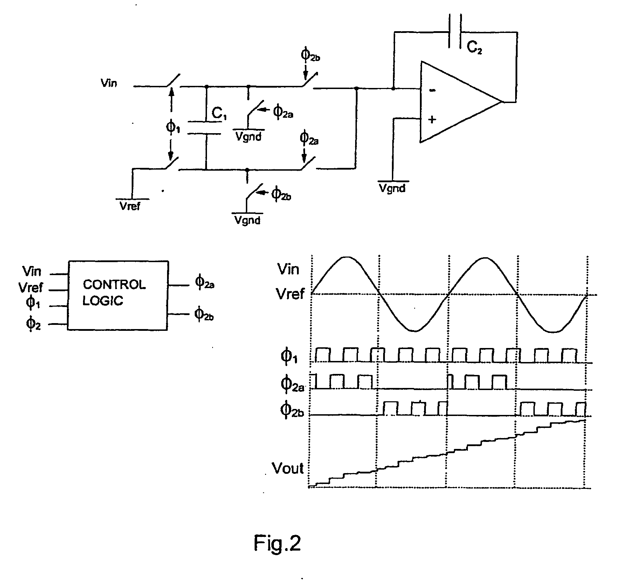

This problem may be overcome by the use of a switched-capacitor integrator as shown in Figure 2, which also function as a rectifier and level shifter.

The input voltage VIN is sampled on the capacitor C1 in respect to the voltage reference VREF. The switches driven by the driving phases Φ₂ₐ and Φ_{2b} of Figure 2 connect the node of the capacitor C1 at the lowest potential to the inverting node of the operational amplifier, while the other node of the capacitor is connected to a common ground node VGND. Hence, the integration and rectification of the input voltage are carried out simultaneously because the integrating capacitor C2 is always charged with voltages of the same sign, regardless of whether VIN is higher or lower than VREF.

The circuit of Figure 2 provides for an output voltage with full dynamic, however it has two drawbacks:
- the operational amplifier of the integrator functions with an input connected to ground VGND, that is at the lowest voltage, thus originating imprecisions in presence of relatively small input signals;
- the switches exhibit parasite capacitances which, when discharged, produce currents in opposition to the integrating current, which brings to a below ground potential the inverting input of the operational at the start of each half-period of integration.

There exists a need for a rectifying integrator able to produce a full dynamic output voltage free of the above noted drawbacks.

### OBJECT AND SUMMARY OF THE INVENTION

The above noted drawbacks are eliminated by the full output voltage dynamic rectifying integrator of this invention. Substantially, the circuit of the invention consists of a pair of integrators, both referred to an intermediate voltage reference within the dynamic voltage range of the input signal and coupled to a pair of respective hold capacitors, which integrate the part of the input signal that either exceeds the voltage reference or remains below the voltage reference, respectively. The voltages on the respective hold capacitors are eventually combined to produce the desired output voltage.

Preferably, the two integrators are combined in a unique integrating stage that is realized according to an offset recovery switched-capacitance technique, using two integrating capacitors coupled to respective hold capacitors at the output to a single amplifier, that are alternatively connected to the integration feedback line of the amplifier depending on whether the input voltage exceeds or remains below the voltage reference. The voltages on the hold capacitors, respectively higher or lower than the voltage reference, are input to a voltage adder which produces an output voltage VOUT corresponding to the difference between the voltages present on the two hold capacitors.

The invention is defined in the annexed claims

### BRIEF DESCRIPTION OF THE DRAWINGS

The various aspects and advantages of the invention will be even clearer upon describing in detail few embodiments of the invention and by referring to the attached drawings, wherein:
**Figure 1** is the functional diagram of a rectifying integrator and of representative signals;
**Figure 2** illustrates the diagrams of a known switched-capacitor rectifier and integrator and of representative signals;
**Figure 3a** is a basic functional diagram of the circuit of the invention;
**Figure 3b** shows an embodiment of the circuit of the invention
**Figure 4** illustrates the main signals of the circuit ofFigure 3b;
**Figure 5** is another embodiment of the circuit of the invention;
**Figure 6** illustrates the main signals of the circuit of Figure 5.

### DESCRIPTION OF EMBODIMENTS OF THE INVENTION

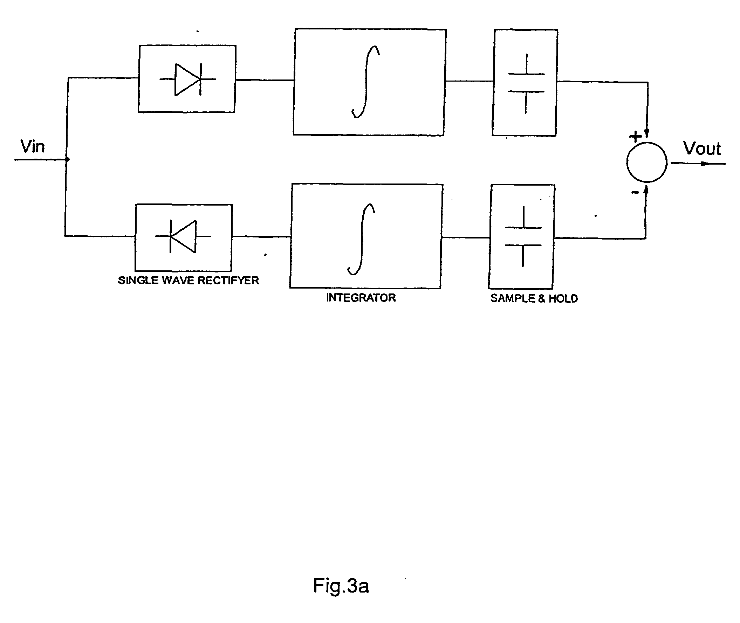

The basic functional scheme of the circuit of the invention is shown in Figure 3a.

The two half-wave rectifiers feed two functionally distinct integrators, both referred to the voltage reference VREF intermediate respect to the voltage range of variation of the input signal Vin, with the portions of the input signal that exceed or are lower than VREF, respectively.

Therefore, each integrator is input with a signal that is always of the same order of magnitude of VREF, so that the hold capacitors SAMPLE&HOLD will be charged with voltages of opposite sign and having a dynamic swing that is substantially halved if compared to the dynamic of the input signal. By subtracting the voltages present on the two hold capacitors by an adder we obtain an output voltage VOUT with a maximum dynamic.

Preferably, the circuit of the invention is realized using a unique integrator, according to a common switched-capacitance technique in order to eliminate offset effects. Two integrating capacitors are alternatively switched to the line of integration depending on whether the voltage VIN exceeds or is lower than the voltage VREF, causing each capacitor to be always charged at voltages of the same sign.

On the output node of the integrator amplifier there will be alternatively two voltages both of a relatively reduced dynamic, one increasing and the other decreasing, which will be stored in the respective hold capacitors. Finally, an adder combines such voltages generating an output voltage of full dynamic.

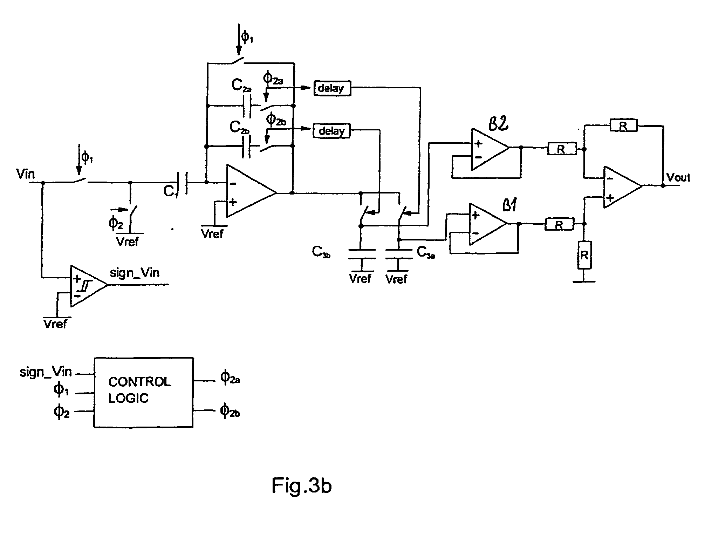

A first practical embodiment of the circuit of the invention is shown in Figure 3b.

The switched input capacitor C₁ is alternately connected to the input voltage and to the voltage reference, by driving in phase opposition of two switches, by the two driving phases signals Φ1 e Φ2

A CONTROL_LOGIC circuit generates sub-phases Φ₂ₐ and Φ_{2b}, of the primary driving phase Φ₂, in function of the two primary driving phases Φ₁ e Φ₂ and in function of the ratio VIN/VREF.

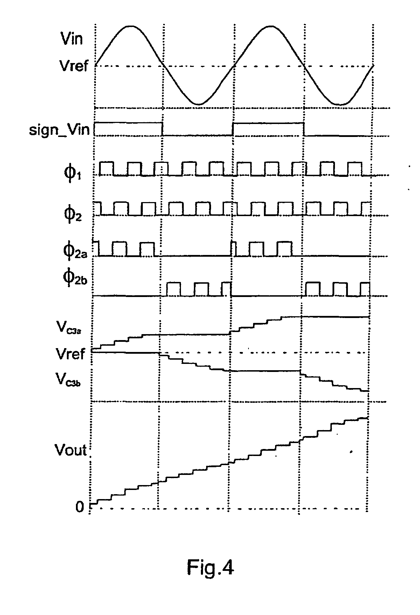

Two integrating capacitors C2a e C2b are alternatively connected to the line of integration of the operational amplifier, by the complementary switching of respective switches driven by the sub-phases Φ2a e Φ2b, as illustrated in the temporal diagrams of Figure 4.

Each integrating capacitor is coupled to a respective hold capacitor C3a and C3b connected to the output of the amplifier by way of a switch that is switched after a certain delay from the sub-phase that drives the respective capacitor of integration.

In the example of Figure 4, when the input voltage exceeds the reference voltage, the capacitor C2a is charged to an increasing voltage VC3a, while the capacitor C2b is charged to a decreasing voltage VC3b.

Two buffers, coupled to respective hold capacitors, feed the voltage supplies to a voltage adder, that generates an output voltage having full dynamic and corresponding to the difference between the two voltages VC3a e VC3b.

Alternatively, the circuit of the invention may include a comparator of the voltages VIN and VREF, producing a signal SIGN_VIN that is fed to the control logic as an indication of the current ratio between the input voltage and the voltage reference.

If the continuous component of the input voltage is equal to the voltage reference, as shown in the example, the voltages on the two hold capacitances will reach their respective maximum values during consecutive half-periods of integration. However, if the continuous component of VIN does not coincide with VREF, one of the two voltages VC3a or VC3b will reach its respective maximum value before the other, and therefore VOUT will not have the maximum dynamic.

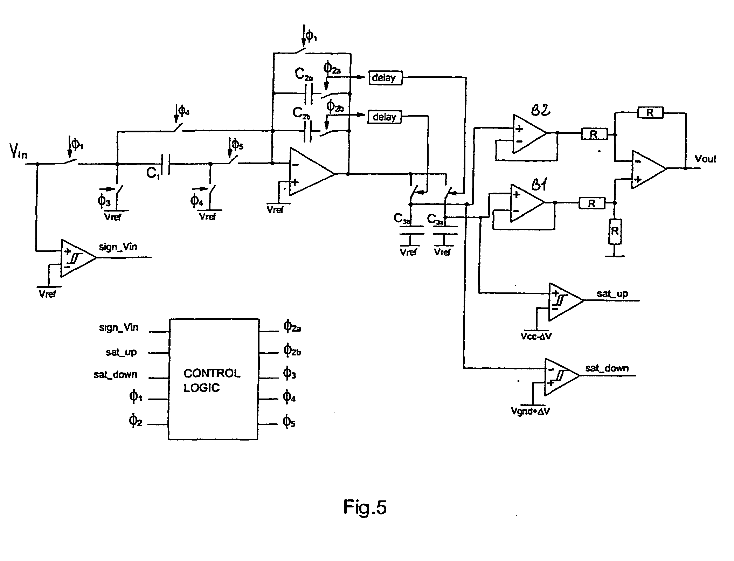

The preferred embodiment of the invention, shown in Figure 5, may be used to prevent this problem.

This circuit differs from the one of Fig. 3b in that the switched input capacitor is linked to the input line through switches driven by three sub-phases Φ3, Φ4 e Φ5 of the primary driving phase Φ2. In addition, two comparators compare the voltages of the respective hold capacitors with the limit voltages VCC-ΔV e VGND+ΔV, and the produced signals: sat_up e sat_down, signal to the Control_Logic the reaching of the maximum voltage (saturation) on any of the two hold capacitors.

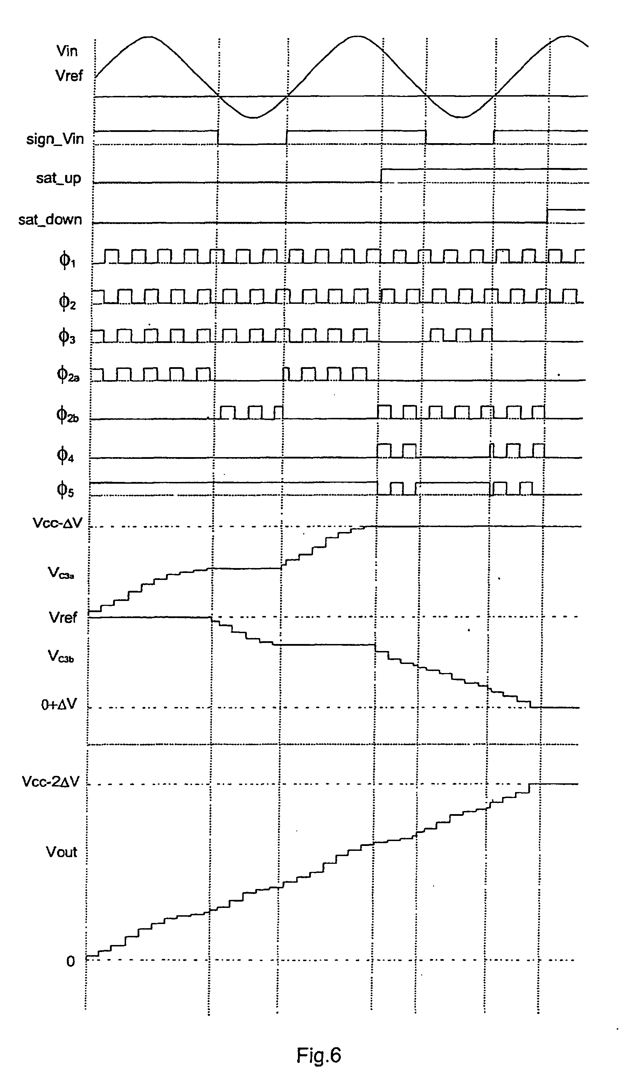

As it may be observed in the signal diagrams of Figure 6, the sub-phases Φ3 e Φ4 are complementary and the sub-phase Φ5 is in phase opposition to Φ4. As long as none of the hold capacitors saturates, the sub-phase Φ3 coincides with Φ2 and the circuit of Figure 5 functions exactly as the one of in Figure 3b.

When any one of the two hold capacitors saturates, in the example of Figure 6 C3a is the first to saturate, the sub-phases Φ4 e Φ5 are modulated such that the capacitor that has not yet reached the respective maximum voltage continues to be charged, whereas the saturated capacitor (C3a) is disconnected (phase Φ2a disabled).

In practice, when the voltage of one of the two hold capacitors reaches saturation level, the connections of the circuit are modified such that the other hold capacitor is charged with a voltage of the same sign, regardless of the ratio between V_{IN} and V_{REF}. When also the voltage on the other hold capacitor reaches the saturation level, the output voltage reaches its maximum value. Similarly, if the capacitor C_{3b} is the first to reach saturation, it will be disconnected (Φ_{2b} disabled).

The above described circuital solution permits to combine in a unique circuital block the rectifying, the integrating and the level shifting functions, thus eliminating the problems of the known circuits.

In particular, the fact of combining in a unique block the above noted functions, permits to eliminate the need to use an amplifier with a gain equal to 2 connected in cascade, which according to certain prior art circuits is required to attain a full output dynamic and to enhance signal/noise ratio.

Finally, the operational amplifier of the integrator functions in respect to the voltage reference in such a way as to ensure that the discharge of the parasite capacitances of the switches, due to their intrinsically small value, will never bring the amplifier of the integrator to function below ground voltage VGND.

## Claims

1. A rectifying integrator of an input signal (VIN) with full output dynamic, relative to a voltage reference (VREF) intermediate in respect to the dynamic of the input signal (VIN), the line of integration of which is composed of an integrator of that portion of the input signal that exceeds the voltage reference (VREF) and of a hold capacitor (C₃ₐ) coupled in cascade to the integrator, including a second line of integration identical to said first line of integration integrates that portion of the input signal (VIN) that remains below said voltage reference (VREF), and an adder output stage generates an output signal (VOUT) equal to the difference between the voltages existing on the hold capacitors (C₃ₐ, C_{3b}) of said lines of integration first and second, said identical lines of integration share a generator of primary control phases, first (φ₁) and second (φ₂) in phase opposition to each other, for offset compensation and integration, and each includes at least an output buffer (B1, B2), said rectifying integrator comprising an integrating stage having two identical capacitors (C₂ₐ, C_{2b}) connected into a feedback path of the integrating stage and two identical hold capacitors (C₃ₐ, C_{3b}) alternately connected to the output of said integrating stage, said distinct output buffers (B1, B2) being coupled to said two hold capacitors (C₃ₐ, C_{3b}), respectively, **characterized in that**
said integrating stage comprises also an operational amplifier (OP-AMP I) said that said identical lines of integration share a common offset free switched-capacitor integrator referred to said intermediate voltage reference (VREF); said identical capacitors (C₂ₐ, C_{2b}), being alternately connected into the feedback path of the operational amplifier by switches driven by a pair of complementary sub-phases (φ₂ₐ, φ_{2b}) of said second primary control phase (φ₂), and
said hold capacitors (C₃ₐ, C_{3b}) being alternately connected to the output of said operational amplifier (OP-AMP-I) by switches controlled by said sub-phases (φ₂ₐ, φ_{2b}) delayed by a certain time interval by a delay circuit (DELAY).

2. The rectifying integrator of claim 1, **characterized in that** it includes two comparators coupled to said hold capacitors (C₃ₐ, C_{3b}), respectively, each generating a saturation signal (SAT_UP, SAT_DOWN) if the voltage on the respective hold capacitor reaches the respective saturation level (V_{CC}-ΔV, V_{GND}+ΔV);
said generator generates control sub-phases, third (φ3) and fourth (φ4) of said second primary phase (φ2), and fifth (φ5) of said first primary phase (φ1), in function of said saturation signals (SAT_UP, SAT_DOWN), said third sub-phase (φ3) being complementary to said fourth sub-phase (φ4) and in phase opposition to said fifth sub-phase (φ5).

3. The circuit according to claim 2, in which said generator switches:
said sub-phases, fourth (φ₄) and fifth (φ₅), only when any one of said saturation signals (SAT_UP, SAT_DOWN) is active; and
the first of said pair of complementary sub-phases (φ₂ₐ, φ_{2b}) only if the hold capacitor driven by it is not saturated while the other hold capacitor is saturated, or else if the input signal (VIN) exceeds the voltage reference (VREF) while both the hold capacitors (C₃ₐ, C_{3b}) are not saturated.

## Patentansprüche

1. Gleichrichtender Integrator eines Eingangssignals (VIN) mit voller Ausgangsdynamik, relativ zu einer Bezugsspannung (VREF), die bezüglich der Dynamik des Eingangssignals (VIN) dazwischen liegt, dessen Integrationskette aus einem Integrator jenes Anteils des Eingangssignals, das die Bezugsspannung (VREF) überschreitet, und aus einem Haltekondensator (C₃ₐ) besteht, der in Kaskade mit dem Integrator gekoppelt ist, der eine zweite Integrationskette, die zur ersten Integrationskette identisch ist, die jenen Anteil des Eingangssignals (VIN) integriert, der unter der Bezugsspannung (VREF) bleibt, und eine Addiererausgangsstufe aufweist, die ein Ausgangssignal (VOUT) erzeugt, das gleich der Differenz zwischen den Spannungen ist, die an den Haltekondensatoren (C₃ₐ, C_{3b}) der ersten und zweiten Integrationsketten vorhanden sind, wobei die identischen Integrationsketten einen Generator erster (φ₁) und zweiter (φ₂) Hauptsteuerphasen, die sich zueinander in Gegenphase befinden, zur Offsetkompensation und Integration gemeinsam nutzen, und jede mindestens einen Ausgangspuffer (B1, B2) aufweist, wobei der gleichrichtende Integrator eine Integrationsstufe aufweist, die zwei identische Kondensatoren (C₂ₐ, C_{2b}), die in einen Rückkopplungsweg der Integrationsstufe geschaltet sind, und zwei identische Haltekondensatoren (C₃ₐ, C_{3b}) aufweist, die abwechselnd mit dem Ausgang der Integrationsstufe verbunden werden, wobei die unterschiedlichen Ausgangspuffer (B1, B2) jeweils mit den beiden Haltekondensatoren (C₃ₐ, C_{3b}) gekoppelt werden, **dadurch gekennzeichnet, daß**
die Integrationsstufe außerdem einen Operationsverstärker (OP-AMP-I) aufweist, so daß die identischen Integrationsketten einen gemeinsamen offsetfreien geschalteten Kondensator-Integrator gemeinsam nutzen, der sich auf die Zwischenbezugsspannung (VREF) bezieht;
die identischen Kondensatoren (C₂ₐ, C_{2b}) durch Schalter, die durch ein Paar komplementärer Teilphasen (φ₂ₐ, φ_{2b}) der zweiten Hauptsteuerphase (φ₂) betrieben werden, abwechselnd in den Rückkopplungsweg des Operationsverstärkers geschaltet werden; und
wobei die Haltekondensatoren (C₃ₐ, C_{3b}) durch Schalter, die durch die Teilphasen (φ₂ₐ, φ_{2b}) gesteuert werden, die durch eine Verzögerungsschaltung (DELAY) um ein bestimmtes Zeitintervall verzögert werden, abwechselnd mit dem Ausgang des Operationsverstärkers (OP-AMP-I) verbunden werden.

2. Gleichrichtender Integrator nach Anspruch 1, **dadurch gekennzeichnet, daß** er zwei Komparatoren aufweist, die jeweils mit den Haltekondensatoren (C₃ₐ, C_{3b}) gekoppelt sind, die jeweils ein Sättigungssignal (SAT_UP, SAT_DOWN) erzeugen, wenn die Spannung am jeweiligen Haltekondensator den jeweiligen Sättigungspegel (V_{CC}-ΔV, V_{GND}+ΔV) erreicht; der Generator als Funktion der Sättigungssignale (SAT_UP, SAT_DOWN) dritte (φ₃) und vierte (φ₄) der zweiten Hauptphase (φ₂), und fünfte (φ₅) der ersten Hauptphase (φ₁) Steuerteilphasen erzeugt, wobei sich die dritte Teilphase (φ₃) komplementär zur vierten Teilphase (φ₄) und in Gegenphase zur fünften Teilphase (φ₅) befindet.

3. Schaltung nach Anspruch 2, in der der Generator schaltet:
die vierten (φ₄) und fünften (φ₅) Teilphasen nur dann,
wenn irgendeines der Sättigungssignale (SAT_UP, SAT_DOWN) aktiv ist; und
die erste des Paares der komplementären Teilphasen (φ₂ₐ, φ_{2b}) nur dann, wenn der durch sie betriebene Haltekondensator nicht gesättigt ist, während der andere Haltekondensator gesättigt ist, oder wenn das Eingangssignal (VIN) die Bezugsspannung (VREF) überschreitet, während beide Haltekondensatoren (C₃ₐ, C_{3b}) nicht gesättigt sind.

## Revendications

1. Intégrateur redresseur d'un signal d'entrée (VIN) avec une pleine dynamique de sortie, par rapport à une référence de tension (VREF) intermédiaire par rapport à la dynamique du signal d'entrée (VIN), dont la branche d'intégration est constituée d'un intégrateur de la partie du signal d'entrée qui dépasse la référence de tension (VREF) et d'un condensateur de maintien (C₃ₐ) couplé en cascade avec l'intégrateur, comprenant une seconde branche d'intégration identique à la première branche d'intégration qui intègre la partie du signal d'entrée (VIN) qui reste en dessous de la référence de tension (VREF), et un étage de sortie additionneur qui génère un signal de sortie (VOUT) égal à la différence entre les tensions existantes sur les condensateurs de maintien (C₃ₐ, C_{3b}) des première et seconde branches d'intégration, les branches d'intégration identiques partageant un générateur de première (φ₁) et seconde (φ₂) phases de commande primaires en opposition de phase l'une par rapport à l'autre pour une compensation de décalage et une intégration, et chacune comprenant au moins un tampon d'entrée (B1, B2), l'intégrateur redresseur comprenant un étage intégrateur comportant deux condensateurs identiques (C₂ₐ, C_{2b}) connectés dans un trajet de réaction de l'étage d'intégration et deux condensateurs de maintien identiques (C₃ₐ, C_{3b}) connectés alternativement à la sortie de l'étage d'intégration, les tampons de sortie distincts (B1, B2) étant couplés aux deux condensateurs de maintien (C₃ₐ, C_{3b}), respectivement, **caractérisé en ce que** :
l'étage d'intégration comprend un amplificateur opérationnel (OP-AMP-I) de sorte que les branches identiques d'intégration partagent un intégrateur à capacités commutées de décalage libre commun référencé à la référence de tension (VREF) intermédiaire, les condensateurs identiques (C₂ₐ, C_{2b}) étant connectés de façon alternée dans le trajet de réaction d'un amplificateur opérationnel par des commutateurs pilotés par une paire de sous-phases complémentaires (φ₂ₐ, φ_{2b}) de la seconde phase de commande primaire (φ₂) ; et
les condensateurs de maintien (C₃ₐ, C_{3b}) étant alternativement connectés à la sortie de l'amplificateur opérationnel (OP-AMP-1) par des commutateurs commandés par les sous-phases (φ₂ₐ, φ_{2b}) retardées d'un certain intervalle de temps par un circuit de retard (DELAY).

2. Intégrateur redresseur selon la revendication 1, **caractérisé en ce que**
il comprend deux comparateurs couplés aux condensateurs de maintien (C₃ₐ, C_{3b}), respectivement, chacun produisant un signal de saturation (SAT_UP, SAT_DOWN) si la tension sur le condensateur de maintien respectif atteint le niveau de saturation respectif (V_{CC}-ΔV, V_{GND}+ΔV) ;
le générateur produit des troisième (φ₃) et quatrième (φ₄) sous-phases de commande de la seconde phase primaire (φ₂) et une cinquième (φ₅) sous-phase de commande de la première phase primaire (φ₁), en fonction des signaux de saturation (SAT_UP, SAT_DOWN), la troisième sous-phase (φ₃) étant complémentaire de la quatrième sous-phase (φ₄) et en opposition de phase avec la cinquième sous-phase (φ₅).

3. Intégrateur redresseur selon la revendication 2, dans lequel le générateur commute :
les quatrième (φ₄) et cinquième (φ₅) sous-phases seulement quand l'un quelconque des signaux de saturation (SAT_UP, SAT_DOWN) est actif ; et
la première de la paire de sous-phases complémentaires (φ₂ₐ, φ_{2b}) seulement si le condensateur de maintien piloté par celle-ci n'est pas saturé tandis que l'autre condensateur de maintien est saturé, ou bien si le signal d'entrée (VIN) dépasse la référence de tension (VREF) tandis que les deux condensateurs de maintien (C₃ₐ, C_{3b}) ne sont pas saturés.
